# EUROPÄISCHE PATENTSCHRIFT

(11) **EP 1 175 700 B1**
(45) Veröffentlichungstag und Bekanntmachung des Hinweises auf die Patenterteilung: **05.12.2012**
(21) Anmeldenummer: 00936637.8
(22) Anmeldetag: 20.04.2000
(51) Int. Cl.: H01L 27/088, H01L 29/78, H01L 29/06, H01L 29/732

(54) **HALBLEITER-BAUELEMENT**
SEMICONDUCTOR COMPONENT
COMPOSANT A SEMI-CONDUCTEUR

(30) Priorität: 21.04.1999 DE 19918028
(43) Veröffentlichungstag der Anmeldung: 30.01.2002
(73) Patentinhaber: Infineon Technologies AG, 85579 Neubiberg (DE)
(72) Erfinder: DEBOY, Gerald, D-80538 München (DE); MÜNDEL, Gerald, D-85560 Ebersberg (DE)
(74) Vertreter: Bickel, Michael
(86) Internationale Anmeldenummer: PCT/DE2000/001251
(87) Internationale Veröffentlichungsnummer: WO 2000/063972

(56) Entgegenhaltungen:
- EP-A- 0 585 788
- DE-A- 4 429 284
- US-A- 5 170 241
- US-A- 5 296 725
- PATENT ABSTRACTS OF JAPAN vol. 015, no. 387 (E-1117), 30. September 1991 (1991-09-30) -& JP 03 155167 A (SANYO ELECTRIC CO LTD), 3. Juli 1991 (1991-07-03)
- DEBOY G ET AL: "NEW GENERATION OF HIGH VOLTAGE MOSFETS BREAKS THE LIMIT LINE OF SILICON" INTERNATIONAL ELECTRON DEVICES MEETING,US,NEW YORK, NY: IEEE, 6. Dezember 1998 (1998-12-06), Seiten 683-685, XP000859463 ISBN: 0-7803-4775-7

## Beschreibung

Die Erfindung betrifft ein spannungsgesteuertes Halbleiter-Bauelement, bei dem zwischen den die Laststrecke bildenden Anschlüssen eine hohe Spannung anliegt.

Die Kosten bei der Fertigung einer Netzstromversorgung stellen ein grundsätzliches Problem dar. Die geeignete Auswahl einer Netzstromversorgung ist abhängig von der Anwendung, ebenso wie die Komponenten, die zum Einsatz kommen sollen. Insbesondere geschaltete Netzstromversorgungen kommen immer häufiger zum Einsatz. Dies liegt unter anderem daran, daß viele komplexe Schaltungsanordnungen eines Schaltnetzteiles auf einem einzigen integrierten Halbleiter-Chip zusammengefaßt werden können. Dies ermöglicht eine kostengünstige Fertigung. Ein derartiger Halbleiter-Chip weist insbesondere eine Leistungsschalteinrichtung sowie eine Ansteuerung für die Leistungsschalteinrichtung auf. Die Lastanschlüsse der Leistungsschalteinrichtung liegen dabei an einer hohen Versorgungsspannung, während zur Ansteuerung der Leistungsschalteinrichtung eine Spannung mit einem wesentlich geringeren Signalpegel benötigt wird. Der integrierte Halbleiterchip weist deshalb Bereiche auf, die für eine Hochvoltanwendung (Leistungsschalteinrichtung) ausgelegt sind und weitere Bereiche, die mit einem niederen Spannungsniveau auskommen (Ansteuerung). Ein derartiger Halbleiterchip benötigt deshalb einen Anschluß, um diesen mit einem hohen Versorgungspotential zu beaufschlagen, sowie einen weiteren Anschluß, der für die Steuerungskomponenten ein niedriges Versorgungspotential zur Verfügung stellt. Das niedere Versorgungspotential kann beispielsweise dadurch erzeugt werden, daß das hohe Versorgungspotential über einen Widerstand zwischen dem weiteren Anschluß und dem hohen Versorgungspotential reduziert wird. Eine derartige Verschaltung verursacht jedoch permanente Verluste.

Es wäre deshalb vorteilhaft, wenn man direkt aus der an der Leistungsschalteinrichtung anliegenden Lastspannung ein Signal ableiten könnte, das einer Ansteuerung zugeführt wird und zu ihrer Versorgung dienen würde. Gleichzeitig sollte die Leistungsschalteinrichtung einen möglichst geringen Durchlaßwiderstand im leitenden Zustand einnehmen.

Eine derartige Leistungsschalteinrichtung ist beispielsweise aus der US 5,285,369 bekannt. Hier wird eine integrierte Schaltungsanordnung beschrieben, die in einer geschalteten Netzversorgung zum Einsatz kommt. Die integrierte Schaltungsanordnung weist dabei eine Leistungsschalteinrichtung auf, die aus zwei seriell miteinander verschalteten Halbleiterschaltern besteht. Der erste Halbleiterschalter ist ein JFET während der zweite Halbleiterschalter ein Hochvolt-MOSFET ist. Am Verbindungspunkt der beiden seriell mit ihren Laststrecken verschalteten Halbleiterschalter kann eine geringe Spannung abgegriffen werden, die einem Spannungsregler der Ansteuereinrichtung zugeführt wird. Hierdurch ist es möglich, in der integrierten Schaltungsanordnung Bauelemente mit hohem und mit niederem Versorgungspotentialbedarf zu vereinen, wobei ein aus der Lastspannung abgeleitetes Signal den Bauelementen mit niederem Versorgungspotential zugeführt werden kann. Der Aufbau der Leistungsschalteinrichtung aus einem JFET und einem Hochvolt - MOSFET ist beispielsweise in der US 4,811,075 oder US 5,313,082 beschrieben.

Nachteilig bei der dort beschriebenen Leistungsschalteinrichtung, im folgenden Halbleiter-Bauelement genannt, ist jedoch das aufwendige Herstellungsverfahren mit sehr vielen Maskenschritten zur Herstellung der komplizierten Schichtenfolge und deren unterschiedlichen Dotierung.

Die US 5,170,241 beschreibt einen Feldeffekttransistor mit einer Vielzahl parallel geschalteter Transistorzellen und mit im Randbereich eines Transistorzellenfeldes angeordneten Halbleiterzonen vom gleichen Leitungstyp wie die Body-Zone der Transistorzellen, die an eine Source-Elektrode angeschlossen sind.

Die JP 03 155 167 A beschreibt einen vertikalen MOSFET mit mehreren parallel geschalteten Transistorstellen und einem Randbereich, in dem floatend angeordnete Halbleitergebiete vorhanden sind, die vom gleichen Leitungstyp wie Bodyzonen der Transistorzellen sind.

Die EP 0585788 A1 beschreibt einen Schaltwandler der eine Kaskodeschaltung mit einem MOSFET und einem JFET aufweist, wobei der MOSFET und der JFET in Reihe zueinander und in Reihe zu der Primärwicklung eines Transformators geschaltet sind. Der MOSFET ist durch eine Ansteuerschaltung angesteuert, die eine Anlaufschaltung besitzt, die an einen den Laststrecken des MOSFET und des JFET gemeinsamen Anschuss angeschlossen ist.

Die Aufgabe der vorliegenden Erfindung besteht deshalb darin, ein Halbleiter-Bauelement anzugeben, das aus einer hohen Lastspannung ein Signal ableiten kann, welches direkt zur Ansteuerung des Halbleiter-Bauelementes oder aber einer Steuereinrichtung verwendet werden kann. Das Halbleiter-Bauelement soll ferner einfach herzustellen sein.

Diese Aufgabe wird mit den Merkmalen der Patentansprüche 1 und 11 gelöst. Patentanspruch 1 beschreibt dabei ein vertikales Halbleiter-Bauelement, während Patentanspruch 11 ein lateral aufgebautes Halbleiter-Bauelement beansprucht.

Im folgenden werden der prinzipielle Aufbau sowie die Wirkungsweise erklärt. Das Halbleiter-Bauelement ist insbesondere als MOSFET oder IGBT ausgebildet. In der Praxis besteht ein derartiges Halbleiter-Bauelement aus einer Vielzahl an parallel geschalteten MOS-Zellen, die auf einer ersten Seite eines Substrats vom ersten Leitfähigkeitstyp eingebracht sind. Zwischen einem Source- und einem Drain-Kontakt liegt die Lastspannung an. Die Höhe des Stromes zwischen dem Source- und dem Drain-Kontakt wird durch die an einem Gate anliegende Spannung eingestellt. Die parallel geschalteten MOS-Zellen bilden das sogenannte aktive Zellenfeld des Halbleiter-Bauelementes und weisen einen ersten Source-Kontakt auf. Dieses Zellenfeld bildet einen ersten Halbleiterschalter.

Um aus der Lastspannung zwischen dem Source- und Drain-Kontakt ein Signal mit einer wesentlich geringeren Spannung ableiten zu können, wird erfindungsgemäß im aktiven Zellenfeld des Halbleiter-Bauelementes ein Bereich von einigen MOS-Zellen mit einem eigenen, zweiten Source-Kontakt versehen. Dies bedeutet nichts anderes, als daß der erste metallische Source-Kontakt, der mit den Source-Gebieten der das aktive Zellenfeld bildenden MOS-Zellen verbunden ist, aufgetrennt wird. Ferner werden bei den weiteren MOS-Zellen (abgetrennte MOS-Zellen) die Gate-Kontakte von den ersten Gate-Kontakten der zum Zellenfeld gewandten MOS-Zellen elektrisch getrennt. Diese Zellen bilden dann einen zweiten Halbleiterschalter der sein Drain mit dem Drain des ersten Halbleiterschalters gemeinsam hat. Die Zellen des zweiten Halbleiterschalters werden im folgenden "Startup-Zellen" genannt. Das Gate der Startup-Zellen wird mit einem ebenfalls getrennt metallisierten "Source-Gebiet" weiterer benachbarter Zellen gut leitend verbunden. Diese Source-Gebiete vom zweiten Leitfähigkeitstyp bilden mit dem Substrat und zumindest einer Wanne der Startup-Zellen, die ebenfalls vom zweiten Leitfähigkeitstyp sind, zumindest einen parasitären Transistor, die im folgenden "Gatedrive-Zelle" genannt werden. Diese Zellen besitzen einen mit dem ersten und dem zweiten Halbleiterschalter gemeinsamen Drain-Anschluß.

Das Potential der "Source-Gebiete" floatet gegenüber Source-Potential der Startup-Zellen als auch gegenüber dem Source-Potential der zum aktiven Zellenfeld gehörenden MOS-Zellen des Halbleiter-Bauelementes. Wird das Source-Potential der Startup-Zellen zum Source-Potential der MOS-Zellen des aktiven Zellenfeldes des Halbleiter-Bauelementes kapazitiv gekoppelt, so steigt in Folge dieser kapazitiven Kopplung bei einer ansteigenden Drain-Source-Spannung am aktiven Zellenfeld auch die Spannung zwischen dem Source-Gebiet der Startup-Zellen und dem Drain-Gebiet des Halbleiter-Bauelementes an. Sämtliche Zellen des Halbleiter-Bauelementes teilen sich das Drain-Gebiet des aktiven Zellenfeldes. Durch die kapazitive Kopplung bildet sich um die Wanne, die das Source-Gebiet der Startup-Zellen umgibt, eine Raumladungszone, die sich sowohl vertikal als auch lateral ausdehnt. Sobald die Raumladungszone das benachbarte "Source-Gebiet" erreicht, werden diese potentialmäßig gekoppelt. Die Spannung, bei der die Raumladungszone die benachbarten Source-Gebiete der Gatedrive-Zellen erreicht, wird im folgenden "Punch-Through-Spannung" genannt. Die Punch-Through-Spannung kann dabei durch die Dotierung des Substrats an der Oberfläche und durch den Abstand zwischen dem Source-Gebiet und den Startup-Zellen eingestellt werden. Idealerweise wird sie auf einen Wert deutlich oberhalb der Einsatzspannung der Startup-Zelle, aber unterhalb deren maximaler Spec-Grenze eingestellt, wobei ein in der Hochvolt-Leistungstechnologie üblicher Wert von 12 V gewählt werden kann. Diese Spannung kann auch bei sehr hohen Drain-Source-Spannungsdifferenzen der MOS-Zellen des aktiven Zellenfeldes nicht überschritten werden. Dies ist insbesondere bei sehr raschen dU/dt-Spitzen im Lastkreis von großer Bedeutung, da mit dem Potential der Sourcegebiete die Gate-Spannung der Startup-Zellen geschaltet werden soll. Durch diese natürliche Begrenzung der an den Source-Gebieten auftretenden Spannung wird ein perfekter Schutz des Gate-Oxids der Startup-Zellen erreicht. Die von den Startup-Zellen aufzubringende Spannung liegt typischerweise zwischen 10 und 15 V. Diese Spannung ist zum Betreiben einer Steuereinrichtung (zum Beispiel ein Steuer-IC) als auch zur direkten Ansteuerung des ersten Gates der MOS-Zellen des aktiven Zellenfeldes ausreichend.

Das erfindungsgemäße Halbleiter-Bauelement weist weiterhin den Vorteil auf, daß auch negative Versorgungspotentiale zwischen dem Source- und Drain-Kontakt des aktiven Zellenfeldes nicht zu einer Zerstörung der Startup-Zellen oder Gatedrive-Zellen (d.h. des Source-Gebietes) führt. Als Schutzelement fungiert dabei die zwischen der Wanne gegenüber dem Substrat der Startup-Zellen bzw. Source-Gebiete gebildete "Body-Diode". Am Gate der Startup-Zellen kann deshalb keine Spannungsdiffenrenz von mehr als -1V gegenüber dem Drain-Gebiet auftreten. Die Potentialdifferenz des zweiten Gates der Startup-Zellen gegenüber dem Source-Potential der Startup-Zellen kann dagegen große Werte annehmen, sofern die Spannung der Startup-Zellen durch einen externen Ladungsspeicher gepuffert wird und nicht begrenzt wird. Beim Einsatz des erfindungsgemäßen Halbleiter-Bauelementes ist deshalb eine externe Spannungsbegrenzung mittels zum Beispiel einer Zenerdiode vorteilhaft. In der Praxis ergibt sich jedoch keine Nutzungseinschränkung, da das Gate-Oxid in den verwendeten Standard-Leistungstechnologien bis 20 V dauerhaft und bis 50V kurzzeitig belastbar ist.

Vorteilhafte Ausgestaltungen der Erfindung sind den Unteransprüchen zu entnehmen.

Die Anordnung der verschiedenen MOS-Zellen ist vorteilhafter dergestalt, daß die Gatedrive-Zellen (bzw. Source-Gebiete vom zweiten Leitfähigkeitstyp) ausschließlich von den Startup-Zellen umgeben sind und zusammen eine die MOS-Zellen des aktiven Zellenfeldes einschaltende Struktur bilden.

Alternativ ist es auch vorstellbar, daß zumindest eine Startup-Zelle ausschließlich von Gatedrive-Zellen (bzw. Source-Gebieten vom zweiten Leitfähigkeitstyp) umgeben ist, wodurch ebenfalls eine die MOS-Zellen des aktiven Zellenfeldes einschaltende Struktur gebildet wird.

Diese das aktive Zellenfeld einschaltende Struktur ist vorteilhafterweise benachbart den MOS-Zellen des aktiven Zellenfeldes anzuordnen oder vollständig von den MOS-Zellen des aktiven Zellenfeldes zu umgeben. Durch diese Vorgehensweise wird erzielt, daß aus der zwischen dem Drain- und Source-Kontakt des aktiven Zellenfeldes anliegenden Spannung ein Signal mit im Vergleich wesentlich geringerer Spannung erzeugt werden kann, das zur Ansteuerung entweder des ersten Gates des Halbleiter-Bauelementes oder aber eines Steuer-ICs verwendet werden kann.

Vorteilhafterweise ist zwischen den MOS-Zellen des aktiven Zellenfeldes und der diese Zellen einschaltenden Struktur eine laterale Isolation vorgesehen, um parasitäre Effekte zu vermeiden.

In einer weiteren vorteilhaften Ausgestaltung ist das Source-Gebiet der Gatedrive-Zelle derart in Richtung der Drain-Elektrode ausgebildet, daß die darin vorhandene Ladung durch die Ausbreitung einer Raumladungszone zwischen den MOS-Zellen der Startup-Zelle und dem Source-Gebiet der Gatedrive-Zelle in der Lage ist, das Gate der Startup-Zelle in jedem Fall sicher anzusteuern. Das Source-Gebiet der Gatedrive-Zellen stellt sich bei Überschreiten einer durch die Ausgestaltung dieses Source-Gebietes vorgebbaren Schwellspannung im Lastkreis des Halbleiter-Bauelementes auf die Punch-Through-Spannung ein.

Zur Ansteuerung des zweiten Gates der Startup-Zelle wird eine minimale Leistung benötigt, da MOS-Gates infolge ihrer kapazitiven Kopplung zum Substrat eine minimale Gateladung benötigen. Diese minimale Ladung muß während der Ausbreitung der Raumladungszone von dem Source-Gebiet der Gatedrive-Zelle gesammelt werden. Gleichzeitig muß das Potential der Source-Gebiete der Gatedrive-Zelle gegenüber dem Source-Potential der Startup-Zelle mindestens um den Betrag der Einsatzspannung der Startup-Zelle höher liegen. Deshalb muß ein mit dem Source-Gebiet der Gatedrive-Zelle verbundenes Ladungsträgerreservoir vorhanden sein.

Dies bedeutet nichts anderes, als daß das Source-Gebiet der Gatedrive-Zelle so ausgestaltet sein muß, daß durch die Bildung eines elektrischen Feldes eine effektive Sammlung der Ladung durch die Gatedrive-Zelle ermöglicht wird. Deshalb wird das Source-Gebiet der Gatedrive-Zelle so ausgestaltet, daß sie sich bei Ausbreitung der Raumladungszone zwischen dem Source-Gebiet der Startup-Zelle und dem Drain-Gebiet komplett ausräumt. Das von diesem Gebiet gegenüber dem Substrat erzeugte lokale elektrische Feld muß so hoch sein, daß die Ausräumladung auch bei einem positiven Potential des Source-Gebietes der Gatedrive-Zelle gegenüber dem Potential der Startup-Zellen bzw. dem Potential der Wannen vom zweiten Leitfähigkeitstyps der MOS-Zellen des aktiven Zellenfeldes in das Source-Gebiet der Gatedrive-Zelle fließt und diese weiter auflädt. Die Ausgestaltung eines derartigen Gebietes, eines vergrabenen Gebietes, ist von sogenannten Kompensationsbauelementen bekannt. Diese Gebiete sind vorteilhafterweise gegenüber einem Standardprozeß bei Kompensationsbauelementen ohne weitere Zusatzmaske einfach herstellbar. Das Herstellungsverfahren ist beispielsweise in der nicht vorveröffentlichten deutschen Anmeldung 198 40 032 beschrieben. Bei einem vertikal ausgebildeten Halbleiter-Bauelement wird deshalb das Source-Gebiet vorteilhafterweise othogonal bzgl. der Hauptseiten des ersten Substrats in Richtung des Drain-Gebietes hin ausgedehnt.

In einer vorteilhaften Ausgestaltung können ebenfalls die Wannen vom zweiten Leitfähigkeitstyp der MOS-Zellen und der Startup-Zellen orthogonal bezüglich einer Hauptseite des Halbleiter-Bauelementes in Richtung der Drain-Elektrode ausgebildet sein. Die Vorteile bestehen darin, daß hierdurch im aktiven Zellenfeld des Halbleiter-Bauelementes eine hohe Avalanche-Festigkeit und eine große Strombelastbarkeit vor bzw. im Durchbruch ermöglicht ist.

Im Falle eines lateral ausgebildeten Halbleiter-Bauelementes wird das Source-Gebiet der Gatedrive-Zellen vorteilhafterweise parallel zu den Hauptseiten des Substrats in Richtung des Drain-Gebietes ausgebildet. Das Source-Gebiet der Gatedrive-Zellen kann dabei entlang der Oberseite im Substrat des Halbleiter-Bauelementes verlaufen.

Die Dimensionierung des Source-Gebietes der Gatedrive-Zelle erfolgt so, daß die Ladung dieses Gebietes ausreicht, das zu schaltende Gate aller Startup-Zellen, deren Gates mit dem Source-Gebiet der Gatedrive-Zellen verbunden sind, mindestens auf die Einsatzspannung der Startup-Zellen aufzuladen. Unter Dimensionierung kann hier sowohl die räumliche Ausgestaltung als auch die Dotierung des Source-Gebietes verstanden werden. Da in der Praxis parasitäre Kapazitäten und Leckströme auftreten ist eine Dimensionierung vorteilhaft, bei der beispielsweise mit einer Gatedrive-Zelle das Gate zweier Startup-Zellen aufgeladen werden kann. Je nach der Ausgestaltung des Source-Gebietes der Gatedrive-Zelle müssen eventuell mehrere Gatedrive-Zellen zur Ansteuerung einer Startup-Zelle verwendet werden.

Um ein unbeabsichtigtes Latchen in dem Source-Gebiet zu verhindern ist es vorteilhaft, dieses ohne ein Gebiet vom ersten Leitfähigkeitstyp auszuführen. Somit wird auch bei einem hohen Löcherstrom ein Einschalten einer parasitären Bipolarstruktur in dem Source-Gebiet verhindert. Die bei der Herstellung einer konventionellen MOS-Zelle übliche Implantation ist deshalb vorteilhafterweise an den Stellen der Gatedrive-Zellen eine Fototechnik abzuschatten.

Da die Startup-Zellen auch bei anliegender hoher Drain-Source-Spannung des aktiven Zellenfeldes einen permanenten Ladestrom liefern, müssen sie sowohl kurzschlußfest als auch thermisch stabil sein. Zur Erzielung der Kurzschlußfestigkeit ist es vorteilhaft eine partielle Abschattung der Kanalanschlußimplantation vorzunehmen. Ein derartiges Vorgehen ist beispielsweise in der nicht vorveröffentlichten deutschen Anmeldung 198 08 348 beschrieben.

In einer weiteren vorteilhaften Ausgestaltung sind die Source-Gebiete gegenüber den Startup-Zellen lateral isoliert zur Bildung von sogenannten "Surge-Detection-Zellen". Die Surge-Detection-Zellen sind derart ausgestaltet, daß die Durchbruchsspannung dieser Zellen unter den Wert der Durchbruchsspannung der MOS-Zellen des aktiven Zellenfeldes liegen. Die Source-Gebiete der Surge-Detection-Zellen können deshalb gegenüber den Wannen vom zweiten Leitfähigkeitstyp der MOS-Zeilen des aktiven Zellenfeldes weniger weit in das Substrat reichen. Diese Gebiete sind vorteilhafterweise zur Kontaktierang mit einem Widerstand vorgesehen. Hierdurch wird auf einfache Weise eine Überspannungsdetektion erzielt. Alternativ oder zusätzlich kann die Dotierung der Surge-Detection-Zelle so gewählt sein, daß ihre Durchbruchsspannung einen geringeren Wert als die Durchbruchsspannung der MOS-Zellen des aktiven Zellenfeldes aufweist, z. B. durch eine Erhöhung der Dotierung des p-Gebietes 13' unterhalb der p-Wanne. Sobald die Drain-Source-Spannung des Halbleiter-Bauelementes die Durchbruchsspannung der Surge-Detection-Zelle überschreitet, fließt in dieser Zelle ein Strom, der das Potential dieser Zelle anhebt. Dieser Spannungsanstieg kann dann z.B. mittels eines Widerstandes detektiert werden und als Auslöser geeigneter Schutzmaßnahmen zum Beispiel durch ein Steuer-IC verwendet werden. Es wäre auch denkbar, über eine geeignete Metallisierung das Gate der MOS-Zellen der aktiven Zellenfelder direkt anzusteuern und zu schützen. Die Variation der Durchbruchsspannung läßt sich am einfachsten dadurch erzielen, daß die Source-Gebiete der Surge-Detection-Zelle weniger weit in das Substrat reichen gegenüber den Wannen vom zweiten Leitfähigkeitstyp der MOS-Zellen des aktiven Zellenfeldes. Dann kann der von den Kompensationselementen bekannte Herstellungsprozeß vorteilhafterweise eingesetzt bzw. variiert werden.

Der Vorteil der Surge-Detection Zelle besteht folglich darin, daß auf einfache Weise eine Aktiv-Zenerung realisiert werden kann, die vollkommen von externen Schaltungsmaßnahmen unabhängig ist. Der Potentialanstieg der Surge-Detection-Zelle kann direkt dazu benutzt werden, über mehrere Startup-Zellen das erste Gate der MOS-Zellen des aktiven Zellenfeldes einzuschalten. Dadurch sinkt die Drain-Source-Spannung des Halbleiter-Bau-elementes und entsprechend das Potential der Surge-Detection-Zelle. Es stellt sich folglich eine stabile Situation ein, bei der eine von 0 verschiedene erste Gatespannung vorliegt und wobei sich eine Drain-Source-Spannung oberhalb der Durchbruchsspannung der Surge-Detection-Zelle aber unterhalb der Durchbruchsspannung des Haupttransistors einstellt. Das Halbleiter-Bauelement ist somit geschützt und kann nicht in den Avalanche gehen.

Bei einer Beschaltung mit einem externen Widerstand wird das erste Gate nur bei Uberschreiten der Durchbruchsspannung der Surge-Detection-Zelle eingeschaltet. Wird jedoch die Schwellenspannung im Bereich der Punch-Through-Spannung des Surge-Detection/ Startup-Zellenfeldes überschritten, bleibt das erste Gate des Halbleiter-Bauelementes ausgeschaltet. Zum Schutz der Surge-Detection-Zelle muß der externe Widerstand so dimensioniert werden, daß bei einer maximalen Stromtragfähigkeit der Surge-Detection-Zelle das Drain-Potential die Durchbruchsspannung des Haupttransistors überschreitet. Bildlich gesehen schneidet man folglich die in etwa rechteckige Durchbruchskennlinie des aktiven Zellenfeldes mit einer Widerstandsgeraden an. Vorteilhafterweise wird die Surge-Detection-Zelle lateral so isoliert, daß der Spannungsanstieg des Source-Gebietes der Surge-Detection-Zelle weder zum Einschalten der Body-Diode gegenüber dem Substrat noch zum Durchbruch gegenüber auf dem Source-Potential liegender Nachbarzellen führt.

Die Dimensionierung der selbsteinschaltenden Struktur aus Startup-Zellen und parasitären Gatedrive-Zellen kann vorteilhafterweise durch eine Kaskadierung mehrerer Stufen von Gatedrive-Zellen bzw. Startup-Zellen erleichtert werden. So kann man beispielsweise mit mehreren Gatedrive-Zellen 10 Startup-Zellen einschalten, wobei deren Ladestrom zum Einschalten von weiteren 1000 Startup-Zellen verwendet wird. Der Strom dieser Zellen kann dann zum raschen Einschalten eines großflächigen aktiven Zellenfeldes genutzt werden.

Falls die Drain-Source-Spannung den Wert des extern gepufferten Source-Potentials der startup-Zellen unterschreitet, erlischt der Ladestrom der Startup-Zellen. Hierdurch läßt sich beispielsweise eine Spannungsnullpunkterkennung oder ein statussignal realisieren.

Zum erneuten Einschalten der Startup-Zellen muß dann die vergrabene Ladung im Source-Gebiet der Gatedrive-Zelle erneuert werden. Da das Potential der Source-Gebiete der Gatedrive-Zelle floatet, kann dies nicht durch eine Diffusion von Löchern aus dem Source-Gebiet selbst geschehen, da von außen kein Strom nachgeliefert werden kann. Die benötigte Ladung kann jedoch durch Injektion von Löchern aus dem Source-Gebiet der Startup-Zellen bereitgestellt werden. Hierzu muß das Source-Gebiet in den Startup-Zellen mit einem kleinen Kondensator verbunden werden, so daß das Potential der Wanne vom zweiten Leitfähigkeitstyp der Startup-zellen auf einer positiven Spannung gehalten wird. Sobald die Drain-Source-Spannung der Startup-Zelle unter dieses Potential sinkt, injiziert die Body-Diode Löcher. Somit wird eine noch vorhandene Raumladungszone unterhalb der Gatedrive-Zelle sehr schnell abgebaut, da die verarmten Source-Gebiete gegenüber dem Substrat in Sperrichtung gepolt sind und damit für die injizierten Löcher in der Nachbarschaft das negativste Potential darstellen. Das Source-Gebiet der Gatedrive-Zelle wird somit mit Löchern geflutet und steht damit einem wiederholten Einschaltzyklus wieder zur Verfügung.

Das erfindungsgemäße Halbleiter-Bauelement ist sowohl für n-Kanal- als auch für p-Kanal-Transistoren einsetzbar. Wird das Halbleiter-Bauelement als IGBT ausgeführt, so wird keine Rücksetzstruktur benötigt, da die Löcher über einen Rückseitenemitter injiziert werden können. Bei starker Injektion an Ladungsträgern kann jedoch das Potential der Gatedrive-Zelle sehr weit über das Potential der Startup-Zelle ansteigen womit die Gefahr einer Gate-Oxid Zerstörung besteht. Dies kann dadurch verringert werden, daß die Spannung zwischen der Startup-Zelle und dem Source-Gebiet der Gatedrive-Zelle begrenzt wird.

Die Erfindung wird anhand der nachfolgenden Figuren näher erläutert. Es zeigen:
- Figur 1: ein einfaches elektrisches Ersatzschaltbild des erfindungsgemäßen Halbleiter-Bauelementes,
- Figur 2: einen Querschnitt durch einen Teil eines erfindungsgemäßen vertikalen Halbleiter-Bauelementes,
- Figur 3: eine Draufsicht auf die prinzipielle Anordnung der Zellen des erfindungsgemäßen vertikalen Halbleiter-Bauelementes,
- Figur 4: ein elektrisches Ersatzschaltbild des erfindungsgemäßen Halbleiterbauelementes, anhand dessen die physikalische Wirkungsweise erklärt werden kann,
- Figur 5: ein weiteres elektrisches Ersatzschaltbild für das erfindungsgemäße Halbleiterbauelement, das das Prinzip der Kaskadierung verdeutlicht,
- Figur 6: eine prinzipielle Zellenanordnung und deren elektrische Verschaltung bei einer Kaskadierung und
- Figur 7: einen Schnitt durch einen Teil eines erfindungsgemäßen lateralen Halbleiter-Bauelementes.

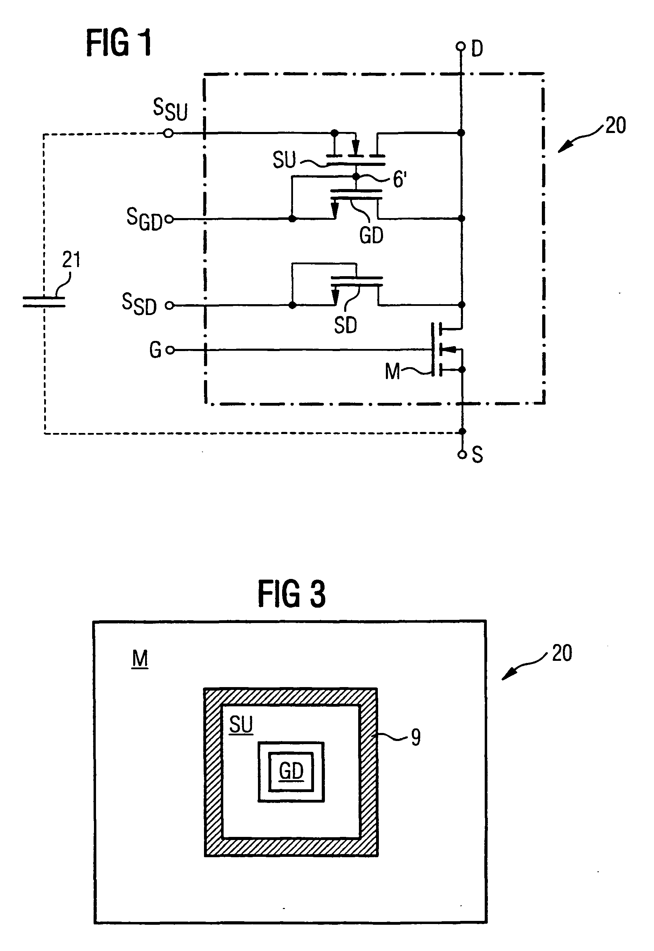

Figur 1 zeigt ein einfaches elektrische Ersatzschaltbild eines erfindungsgemäßen Halbleiter-Bauelementes 20. Das Halbleiter-Bauelement 20 weist einen n-Kanal-MOSFET M auf, der aus einer Vielzahl an parallel geschalteten MOS-Zellen gebildet ist, die das aktive Zellenfeld des Halbleiter-Bauelementes 20 darstellen. Ein Drain-Anschluß D und ein Source-Anschluß S bilden die beiden Lastanschlüsse des Halbleiter-Bauelementes 20. An den Lastanschlüssen D, S liegt eine hohe Spannung an, die zum Beispiel im Bereich von mehreren 100 V liegen könnte. Ferner ist ein weiterer n-Kanal-MOSFET SU vorgesehen, der mit seinem Drain-Anschluß mit dem Drain-Anschluß D des MOSFETs M verbunden ist. Ein parasitärer Transistor GD ist mit seinem Drain-Anschluß ebenfalls mit dem Drain-Anschluß D des MOSFETs M verbunden. Sein Gate-Anschluß ist einerseits mit dem Gate-Anschluß des MOSFETs SU und andererseits mit dem Source-Anschluß S_{GD} des Transistors GD verbunden. Das Potential des Source-Anschlusses S_{GD} floatet gegenüber dem Source-Potential der MOSFETs M und SU.

In der Praxis wird ein Kondensator 21 zwischen dem Source-Kontakt S des MOSFETs M und dem Source-Kontakt S_{SU} des MOSFETs SU angeschlossen sein, wie dies in der Figur 1 strichliert angedeutet ist. Durch die kapazitive Kopplung der beiden Source-Anschlüsse ist der parasitäre Transistor GD beim Überschreiten einer bestimmten Schwellenspannung zwischen dem Drain-Anschluß D und dem Source-Anschluß S in der Lage, den MOSFET SU leitend zu schalten, der dann beispielsweise einen Steuer-IC mit einem im Vergleich zu den Lastanschlüssen niedrigen Spannungspotential ansteuern könnte, welcher seinerseits mit dem Gate G des MOSFETs zur Ansteuerung verbunden sein könnte. Die Höhe der Schwellenspannung, bei der der Halbleiter-Schalter SU leitend gesteuert wird, kann durch technologische Maßnahmen (Implantationsdosis, Gateoxiddicke) festgelegt werden.

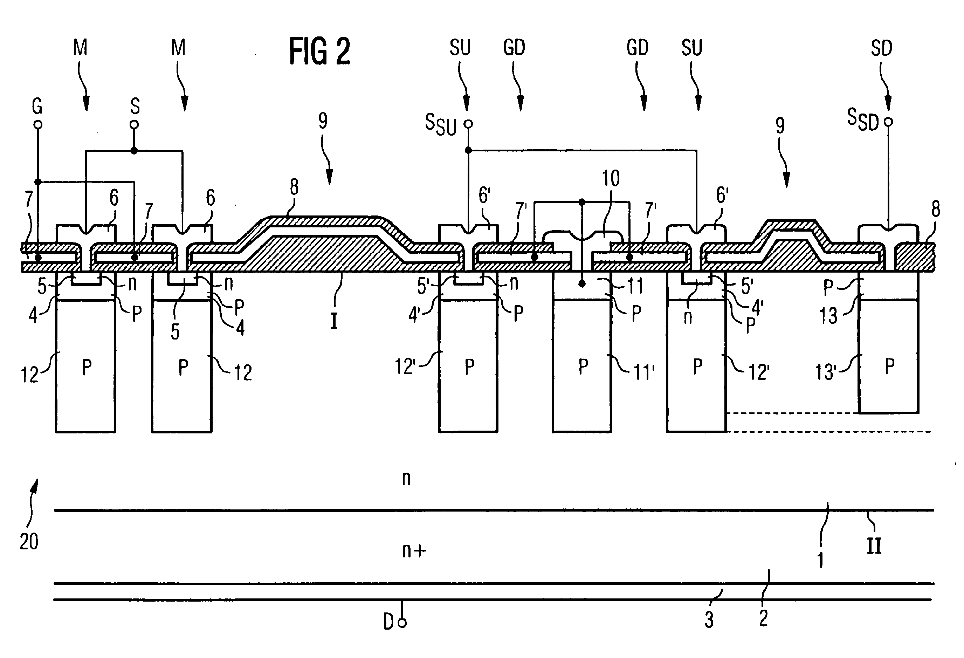

Die Figur 2 zeigt einen Querschnitt durch das erfindungsgemäße vertikale Halbleiter-Bauelement. Das Halbleiter-Bauelement 20 weist ein Substrat 1 mit einer ersten Seite I und einer zweiten Seite II auf, welches im vorliegenden Beispiel n-leitend ist. Auf der zweiten Seite II ist ein hochdotiertes Gebiet vom gleichen Leitfähigkeitstyp angeordnet, welches das Drain-Gebiet 2 darstellt. Auf dem Drain-Gebiet 2 ist auf der vom Substrat 1 abgewandten Seite eine Metallisierung aufgebracht, die einen Drain-Kontakt 3 darstellt.

Auf der ersten Seite I des Substrates 1 ist eine Vielzahl an MOS-Zellen M vorgesehen, wobei stellvertretend für die Vielzahl nur zwei MOS-Zellen M dargestellt sind. Eine MOS-Zelle M weist dabei eine in das Substrat 1 eingebrachte und an die erste Seite I reichende erste Wanne 4 von einem dem Substrat entgegengesetzten Leitungstyp, im vorliegenden Fall p, auf. In dieser p-Wanne 4 ist ein erstes Source-Gebiet 5 eingebracht, das n-leitend ist. Dieses Source-Gebiet 4 reicht an die erste Seite I des Substrats 1.

Auf der ersten Seite I des Substrats 1 ist eine Isolierschicht 8 aufgebracht. Diese Isolierschicht 8 ist an den Stellen der ersten Source-Gebiete 5 der MOS-Zellen M durchbrochen, so daß das erste Source-Gebiet 5 mit einem ersten Source-Kontakt 6 elektrisch leitend in Verbindung steht. Auf der Isolierschicht 8 ist ein erstes Gate 7 aufgebracht, das die p-Wanne 4 teilweise überdeckt und ebenfalls über einen (nicht gezeigten) metallischen Gate-Kontakt verbunden ist.

Durch eine laterale Isolation 9 von den MOS-Zellen M getrennt sind in dem Substrat 1 weitere MOS-Zellen SU vorgesehen. Die weiteren MOS-Zellen, sogenannte Startup-Zellen SU sind dabei genauso wie die MOS-Zellen M aufgebaut. Dies bedeutet, in das substrat 1 ist eine p-Wanne 4' eingelassen, in welche ihrerseits ein Source-Gebiet 5', das an die erste Seite I reicht, eingelassen ist. Das Source-Gebiet 5' ist mit einem zweiten Source-Kontakt 6', welcher durch die Isolierschicht 8 reicht, elektrisch verbunden. Der erste und der zweite Source-Kontakt 6, 6' weisen keine elektrische Verbindung zueinander auf; gleiches gilt für die entsprechenden (nicht gezeigten) Gate-Kontakte.

Auf der Isolierschicht 8 befindet sich ein zweites Gate 7', welches die p-Wanne 4' zumindest teilweise überdeckt. Das Gate 7' überdeckt weiterhin teilsweise ein Source-Gebiet 11, das zusammen mit der p-Wanne 4' und dem Substrat 1 einen parasitären pnp-Transistor bildet. Dieser wird als sogenannte Gatedrive-Zelle GD bezeichnet. Die Gatedrive-Zellen GD stehen mit dem Gate 7' in elektrischer Verbindung. Die elektrische Verbindung dem Gate 7' zum Beispiel über eine metallische Kontaktierung 10 erfolgen.

Um beim Uberschreiten einer Schwellenspannung zwischen dem Drain-Kontakt 3 und dem ersten Source-Kontakt 6 des Halbleiter-Bauelementes ein Durchschalten der Startup-Zellen SU sicherzustellen, ist das p-Gebiet 11 so beschaffen, daß die darin befindliche Ladung ausreicht, das zweite Gate 7' auf ein ausreichend hohes Potential zu bringen. Deshalb ist unterhalb des p-Gebietes 11 ein weiteres Gebiet 11' vom gleichen Leitfähigkeitstyp vorgesehen, das elektrische gut leitend mit dem p-Gebiet 11 verbunden ist. In der Figur 3 ist die bevorzugte Ausgestaltung der p-Gebiete 11, 1' dargestellt, das heißt das p-Gebiet 11' erstreckt sich othogonal von der ersten Seite I zur zweiten Seite II des Halbleiter-Bauelementes. Um die Strombelastbarkeit vor bzw. im Durchbruch zu erhöhen und auch eine hohe Avalanche-Festigkeit der MOS-Zellen M zu erreichen, ist unterhalb der p-Wannen 4 ebenfalls ein othogonal zur ersten Seite I ausgebildetes p-Gebiet 12 vorgesehen. Gleiches gilt ebenfalls für die Startup-Zellen SU, in denen unterhalb der zweiten p-Wanne 4' ein vergrabenes p-Gebiet 12' vorhanden ist.

In der Figur ist das vergrabene p-Gebiet 11 von (im Querschnitt) zwei Startup-Zellen SU umgeben. Denkbar wäre auch, eine Startup-Zelle SU mit vergrabenen p-Gebieten 11 zu umgeben.

Weiterhin ist in Figur 3 eine sogenannte Surge-Detection-Zelle SD dargestellt, die prinzipiell ähnlich wie eine Gatedrive-Zelle GD aufgebaut ist. Auch die Surge-Detection-Zelle ist SD weist unterhalb ihres p-Gebietes SD ein vergrabenes p-Gebiet 13 auf, das jedoch gegenüber den p-Gebieten 12 der MOS-Zellen M weniger weit in Richtung der zweiten Seite ausgebildet ist. Hierdurch weist die Surge-Detection-Zelle SD gegenüber der MOS-Zelle M eine verringerte Durchbruchsspannung auf. Sie kann dann bei Beschaltung mit einem externen Widerstand als Überspannungsdetektion verwendet werden. Weiterhin ist bei geeigneter Verschaltung mit den Startup-Zellen eine aktive Zenerung des Halbleiter-Bauelementes möglich. Die Surge-Detection-Zelle SD ist weiterhin lateral gegenüber den Startup-Zellen SU isoliert.

Wird die hochdotierte n+-Schicht 2 durch eine p-Schicht ersetzt, so ist das Halbleiter-Bauelement als IGBT ausgeführt, während in der vorliegenden Zeichnung ein MOSFET die Grundstruktur bildet.

Figur 3 zeigt eine mögliche Anordnung der verschiedenen Zellentypen des erfindungsgemäßen Halbleiter-Bauelementes in einer Draufsicht. Im vorliegenden Fall sind die Gatedrive-Zellen GD ausschließlich von Startup-Zellen SU umgeben. Es wäre jedoch auch denkbar, mehrere Startup-Zellen ausschließlich mit Gatedrive-Zellen zu umgeben. Diese Anordnung ist ihrerseits wiederum von einer lateralen Isolation umgeben, die wiederum von MOS-Zellen M umgeben ist. Das Layout der einzelnen Zellen kann dabei in bekannter Weise erfolgen. Es ist ein Streifenlayout möglich, die Zellen können einen kreisförmigen Querschnitt aufweisen und eine hexagonale Flächenpackung einnehmen oder bei einem kreisförmigen Querschnitt eine in etwa quadratische Flächenpackung einnehmen oder einen streifenförmigen Querschnitt aufweisen. Gleiches gilt für die Ausgestaltung der Startup-Zellen und der Gatedrive-Zellen.

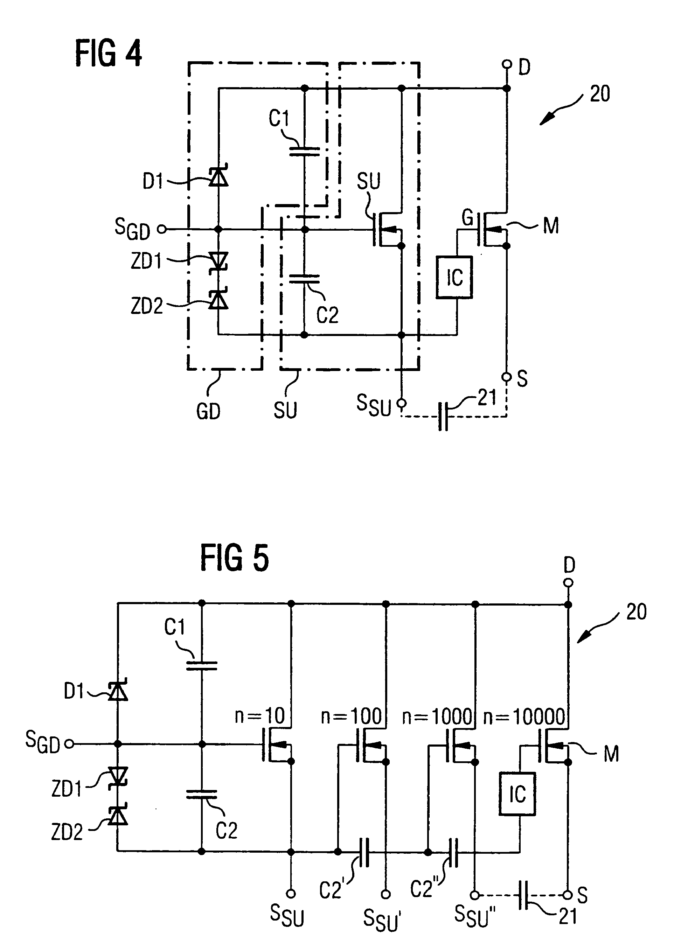

Figur 4 zeigt ein elektrisches Ersatzschaltbild für das aus Figur 3 bekannte, erfindungsgemäße Halbleiterbauelement, anhand dessen die physikalische Wirkungsweise besonders gut ersichtlich wird. Das erfindungsgemäße Halbleiterbauelement 20 weist einen MOSFET M auf, der aus einer Vielzahl der parallel geschalteten MOS-Zellen besteht, die das aktive Zellenfeld bilden. Drainseitig ist der MOSFET M mit dem Drainanschluß eines weiteren MOSFET SU verbunden. Sourceseitig ist der MOSFET SU über einen integrierten Schaltkreis IC mit dem Gate G des MOSFETs M verbunden. Es wäre auch denkbar, den Source-anschluß des MOSFETs SU direkt mit dem Gate des MOSFETs M zu verbinden. Mit C2 ist eine Kapazität bezeichnet, die die Gate-Source-Kapazität des MOSFETs SU darstellt. Zwischen dem Gate und dem Drainanschluß des MOSFETs SU ist eine weitere Kapazität C1 verschalten. Diese Kapazität repräsentiert die in dem vergrabenen p-Gebiet 11, 11' vorhandene Ladung (Raumladungszonenkapazität). Der Kapazität C1 ist weiterhin eine Diode D1 parallel geschaltet, wobei deren Anodenanschluß mit dem Gate des MOSFETs SU in Verbindung steht, während der Katodenanschluß mit dem Drainanschluß D verbunden ist. Zwischen dem Gate und dem Source des MOSFETs SU sind zwei Zenerdioden ZD1, ZD2 antiseriell verschalten. Dies bedeutet der Anodenanschluß der Zenerdiode ZD1 steht mit dem Gate des MOSFETs SU in Verbindung, die Katodenanschlüsse der Zenerdioden ZD1, ZD2 sind miteinander verbunden, während der Anodenanschluß der Zenerdiode ZD2 mit dem Source S_{SU} des MOSFETs SU verbunden ist. Die Kapazität C1, die Diode D1 sowie die beiden Zenerdioden ZD1, ZD2 bilden die Gatedrive-Zelle GD. Das Gate des MOSFETs SU stellt fernerhin den "Source-Anschluß S_{GD}" der Gatedrive-Zelle GD dar. In der Figur ist ferner strichliert ein externer Ladungsspeicher 21 dargestellt, der zwischen den Sourceanschlüssen, den MOSFETs SU, M verschalten ist.

Die Diode D1 stellt den Übergang zwischen dem vergrabenen p-Gebiet 11, 11' und dem Substrat 1 dar. Die antiseriell verschalteten Zenerdioden ZD1, ZD2, bilden den parasitären Transistor zwischen dem vergrabenen p-Gebiet 11, dem Substrat 1 sowie der p-Wanne 4' der Startup-Zelle SU. Die Beabstandung zwischen der Startup-Zelle und dem vergrabenen p-Gebiet 11, 11' ist derart, daß die beiden Zenerdioden ZD1, ZD2 idealerweise eine Sperrspannung von ca. 8 Volt aufweisen. Die Dimensionierung von ZD1, ZD2 sollte im Idealfall identisch sein. Die Einsatzspannung des MOSFETs SU sollte bei ca. 4 bis 5 Volt liegen. Das Leitendschalten des MOSFETs M durch Anlegen einer hohen Spannung zwischen den Drain- und den Sourceanschluß kann wie folgt erklärt werden: Die Gatedrive-Zelle GD dient als Steuerelektrode für den MOSFET SU. Dies bedeutet, in der Gatedrive-GD selbst fließt kein Strom, es wird lediglich beim Anlegen einer hohen Spannung zwischen dem Drain- und Sourceanschluß ein Strom zum Aufladen des Gates des MOSFETs SU bereitgestellt. Die Kapazität C1 bildet zusammen mit den antiseriell verschalteten Zenerdioden ZD1, ZD2 einen Spannungsteiler. Beim Anlegen der hohen Spannung zwischen den Drainanschluß D und den Sourceanschluß S beginnt das Potential am Mittelabgriff dieses Spannungsteilers zu steigen. Die in der Kapazität C1 gespeicherte Ladung, die aus dem vergrabenen Gebiet 11, 11' bereitgestellt wird, beginnt die Gate-Source-Kapazität C2 des MOSFETs SU aufzuladen. Hierdurch bedingt schaltet der MOSFET SU durch, es kann ein Strom zum Sourceanschluß S_{SU} des MOSFETs SU fließen. Bedingt durch die externe Kapazität 21 beginnt das Potential am Sourceanschluß S_{SU} anzusteigen. Die Zenerdiode ZD2 übernimmt nun eine spannungsbegrenzende Funktion, d.h. die Spannung zwischen dem Gateanschluß und dem Sourceanschluß des MOSFETs SU wird auf einem Wert von ca. 8 Volt gehalten. Dieser Wert kann durch die Dimensionierung der Zenerdioden ZD1, ZD2 eingestellt werden. Aufgrund dieser permanenten Potentialdifferenz bleibt der MOSFET SU leitend.

Die Kapazität 21 ist nun so dimensioniert, daß der am Source-anschluß S_{SU} anliegende Spannungswert eine Höhe erreicht, mit der der integrierte Schaltkreis IC angesteuert werden kann. Dieser kann nun in geeigneter Weise das Gate des MOSFETs M ansteuern und diesen leitend schalten.

Das Ausschalten des MOSFETs M wird erst dann erreicht, wenn sich der MOSFET SU in einem gesperrten Zustand befindet. Hierzu ist es denkbar, den Sourceanschluß S_{SU} mit dem Source-anschluß S des MOSFETs M kurzzuschließen. Andererseits wäre es auch denkbar, den Sourceanschluß S_{SU} mit dem Sourceanschluß S_{GD} zu verbinden, so daß die Kapazität C2 entladen werden könnte.

Die Diode D1 repräsentiert gleichzeitig eine Surge-Detection-Zelle SD. Durch eine geeignete Dimensionierung, die entweder durch die Dotierung oder aber die Tiefe des vergrabenen Gebietes 13' bestimmt wird, ist eine aktive Zenerung des MOSFETs M möglich. Die Durchbruchsspannung der Diode D1, die dann als Zenerdiode wirkt, muß so eingestellt werden, daß sie kleiner ist als die Durchbruchsspannung des MOSFETs M. Wird die Durchbruchsspannung der Diode D1 überschritten, so liefert sie einen Ladestrom für das Gate des MOSFETS S_{SU}, der in der beschriebenen Weise leitend gesteuert wird, und auf diese Weise den MOSFET M aufsteuert. Hierdurch kann eine Zerstörung des MOSFETs M verhindert werden.

Wie bereits im einleitenden Teil erwähnt, ist es auch denkbar, bei geeigneter Dimensionierung aller gezeigten Bauelemente, das Gate des MOSFETs M direkt mit dem Sourceanschluß des MOSFETs SU zu verbinden.

Figur 5 zeigt eine Erweiterung des Ersatzschaltbildes aus Figur 4. In dieser Figur ist eine Kaskadierung der Startup-Zellen verdeutlicht. Werden beispielsweise durch die Kapazität C1 die Gates von zehn Startup-Zellen SU aufgeladen, so kann mit dem am Sourceanschluß S_{SU} erzeugten Strom das Gate von jeweils weiteren zehn Startup-Zellen S_{SU}' angesteuert werden. Insgesamt leiten also 100 Startup-Zellen S_{SU}', die wiederum jeweils zehn weitere Startup-Zellen S_{SU} " leitend steuern können. Es stehen dann 1000 Startup-Zellen S_{SU} " zur Verfügung, die die externe Kapazität 21 aufladen können. Mittels dieser einfachen Kaskadierung ist es möglich, auch ein großes aktives Zellenfeld (MOSFET M) anzusteuern. Im beschriebenen Beispiel wurde davon ausgegangen, daß eine Startup-Zelle SU in der Lage ist, zehn weitere Zellen leitend zu steuern. Entsprechend der Anzahl der Kaskadierungs-Stufen kann eine beliebige Ladung erzeugt werden, die ausreicht, einen MOSFET M leitend zu steuern.

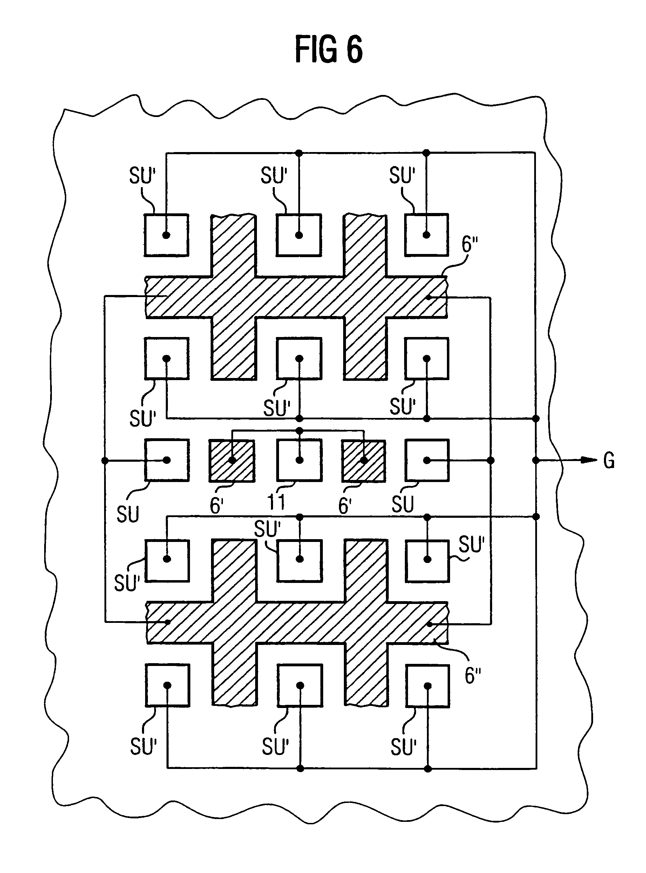

In Figur 6 ist eine Draufsicht auf ein derartig kaskadiertes Zellenfeld dargestellt. Ein vergrabenes p-Gebiet 11 ist elektrisch mit zwei benachbarten Gates 6' verbunden. Die Gates 6' steuern die benachbarten Startup-Zellen SU auf, die Sourceseitig mit weiteren Gates 6" elektrisch verbunden sind. Mittels der Gates 6" können weitere 12 Startup-Zellen SU' aufgesteuert werden, die dann beispielsweise direkt mit dem Gate des MOSFETs M verbunden werden können.

Bei einer Kaskadierung der Startup-Zellen muß beachtet werden, daß die Gate-Metallisierung jeder Kaskade extern kontaktierbar ist. Um ein Abschalten des MOSFETs M zu erzielen, muß jede einzelne Kaskadierungs-Stufe abgeschaltet werden, so daß keinem der Startup-Zellen eine Ladung "stehen bleibt".

In Figur 6 weisen die dargestellten Zellen ein quadratisches Layout auf. Es ist selbstverständlich auch denkbar, daß die zellen kreisförmig oder hexagonal ausgebildet sind.

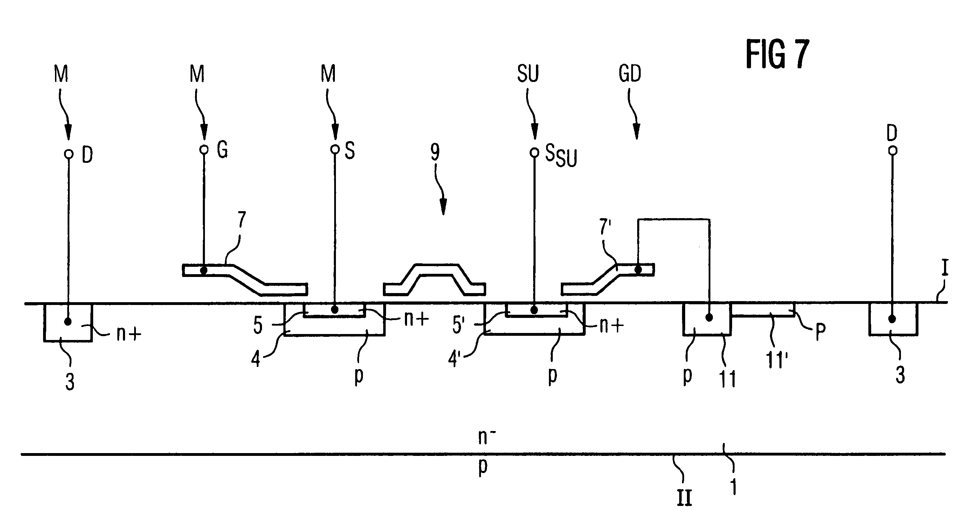

Figur 7 zeigt einen "Querschnitt durch ein lateral aufgebautes Halbleiter-Bauelement. Die Figur 7 zeigt auf der linken Seite die in bekannter Weise aufgebauten MOS-Zellen M. Gleichermaßen wie beim vertikal aufgebauten Halbleiter-Bauelement sind die Startup-Zellen S1 mit einem eigenen, zweiten Source-Kontakt versehen. Dieser zweite Source-Kontakt 6' ist gegenüber dem ersten Source-Kontakt 6 der MOS-Zellen M elektrisch isoliert. Die gegenseitige Isolation der Zellen wird durch eine laterale Isolation 9 bewerkstelligt. Die Gatedrive-Zelle GD ist als parsitärer Transistor zwischen dem vergrabenen p-Gebiet 11, dem Substrat 1 und der p-Wanne 4' ausgeführt, wobei die zum Laden des zweiten Gates 7' notwendige Ladung in den vergrabenen p-Gebieten 11, 11' vorhanden ist. Das vergrabene p-Gebiet 11' erstreckt sich von dem p-Gebiet 11 in Richtung des Drains 3 entlang der ersten Seite I des Substrates 1. Das vergrabene p-Gebiet 11' steht in gutem elektrischem Kontakt zum p-Gebiet 11. Ferner ist es nunmehr selbstverständlich, daß das p-Gebiet 11 mit dem zweiten Gate 7' elektrisch verbunden ist.

Mit dem vorliegenden Halbleiter-Bauelement ist es möglich, aus einer hohen Lastspannung an den Lastanschlüssen eines MOSFETs oder IGBTs ein Signal zu erzeugen, das zur Ansteuerung eines Steuer-ICs oder direkt der Steuerelektrode des Halbleiter-Bauelementes geeignet ist.

## Patentansprüche

1. Vertikales Halbleiter-Bauelement mit folgenden Merkmalen:
- einem Substrat (1) vom ersten Leitfähigkeitstyp mit einer ersten und einer zweiten Seite (I, II), das auf der ersten Seite (I) von einer Isolierschicht (8) bedeckt ist;
- einer auf der zweiten Seite (II) aufgebrachten, höher dotierten Schicht (2) vom ersten Leitfähigkeitstyp, auf der ein metallischer Drainkontakt (3) aufgebracht ist;
- einer Vielzahl an MOS-Zellen (M) auf der ersten Seite des Substrats (1) zur Bildung eines ersten Halbleiter-Schalters, wobei eine MOS-Zelle jeweils aufweist:
- eine in das Substrat eingebrachte und an die erste Seite reichende erste Wanne (4) vom zweiten Leitfähigkeitstyp,
- ein in die erste Wanne (4) eingelassenes erstes Source-Gebiet (5) vom ersten Leitfähigkeitstyp, das an die erste Seite des Substrats (1) reicht und mit einem ersten metallischen Source-Kontakt (6), der sich durch die Isolierschicht (8) erstreckt, verbunden ist,
- ein erstes Gate (7) auf der vom Substrat (1) abgewandten Seite der Isolierschicht (8), das die erste Wanne (4) teilweise überdeckt und mit einem metallischen Gate-Kontakt verbunden ist;
- einer Mehrzahl an weiteren MOS-Zellen (SU) zur Bildung eines zweiten Halbleiter-Schalters, der mit dem ersten Halbleiter-Schalter einen gemeinsamen Drain-Anschluß besitzt, wobei die weiteren MOS-Zellen (SU) jeweils aufweisen:
- eine in das Substrat eingebrachte und an die erste Seite reichende zweite Wanne (4') vom zweiten Leitfähigkeitstyp, ein in die zweite Wanne (4') eingelassenes zweites Source-Gebiet (5') vom ersten Leitfähigkeitstyp, das an die erste Seite des Substrats (1) reicht und das mit einem zweiten metallischem Source-Kontakt (6') auf der ersten Seite (I), der sich durch die Isolierschicht (8) erstreckt, verbunden ist,
- ein zweites Gate (7') auf der vom Substrat (1) abgewandten Seite der Isolierschicht (8), das die zweite Wanne (4') teilweise überdeckt und mit einem metallischem Gate-Kontakt verbunden ist;
**dadurch gekennzeichnet, dass**
der zweite Source-Kontakt (6') von dem ersten Source-Kontakt (6) elektrisch isoliert ist und dass
zumindest ein in das Substrat eingelassenes und an die erste Seite reichendes Gebiet (11, 11') vom zweiten Leitfähigkeitstyp vorhanden ist, das mit dem zweiten Gate (7') der weiteren MOS-Zellen (SU) in elektrischer Verbindung steht und das floatend gegenüber dem ersten und zweiten Source-Gebiet (5, 5') angeordnet ist.

2. Vertikales Halbleiter-Bauelement nach Patentanspruch 1,
**dadurch gekennzeichnet, daß**
ein Gebiet (11, 11') vom zweiten Leitfähigkeitstyp ausschließlich von den weiteren MOS-Zellen (SU) umgeben ist.

3. Vertikales Halbleiter-Bauelement nach Patentanspruch 1,
**dadurch gekennzeichnet, daß**
zumindest eine der weiteren MOS-Zellen (SU) ausschließlich von Gebieten (11, 11') vom zweiten Leitfähigkeitstyp umgeben ist.

4. Vertikales Halbleiter-Bauelement nach Patentanspruch 2 oder 3,
**dadurch gekennzeichnet, daß**
eine Struktur (11, 11', SU) mit den weiteren MOS-Zellen (SU) und dem Gebiet (11, 11') vom zweiten Leitfähigkeitstyp benachbart zu den MOS-Zellen (M) des ersten Halbleiter-Schalters angeordnet ist oder von den MOS-Zellen (M) umgeben ist.

5. Vertikales Halbleiter-Bauelement nach einem der Patentansprüche 2 bis 4,
**dadurch gekennzeichnet, daß**
zwischen den MOS-Zellen (M) und der Struktur (11, 11', SU) mit den weiteren MOS-Zellen (SU) und dem Gebiet (11, 11') vom zweiten Leitfähigkeitstyp eine laterale Isolation (9) vorgesehen ist.

6. Vertikales Halbleiter-Bauelement nach einem der Patentansprüche 1 bis 5,
**dadurch gekennzeichnet, daß**
das Gebiet (11, 11') des zweiten Leitfähigkeitstyps derart in Richtung der zweiten Seite (II) ausgebildet ist, daß die darin vorhandene Ladung durch die Ausbreitung einer Raumladungszone zwischen den weiteren MOS-Zellen (SU) und dem Gebiet (11, 11') des zweiten Leitfähigkeitstyps in der Lage ist, das Gate der weiteren MOS-Zellen (SU) anzusteuern.

7. Vertikales Halbleiter-Bauelement nach Patentanspruch 6,
**dadurch gekennzeichnet, daß**
die Gebiete (11') des zweiten Leitfähigkeitstyps orthogonal von der ersten Seite (I) zur zweiten Seite (II) hin ausgedehnt sind.

8. Vertikales Halbleiter-Bauelement nach einem der Patentansprüche 1 bis 7,
**dadurch gekennzeichnet, daß**
die Wannen (4, 4') der MOS-Zellen (M) und der weiteren MOS-Zellen (SU) orthogonal von der ersten Seite (I) zur zweiten Seite (II) ausgedehnt sind.

9. Vertikales Halbleiter-Bauelement nach einem der Patentansprüche 1 bis 8,
**dadurch gekennzeichnet, daß**
einige Gebiete (13) der Gebiete (11) des zweiten Leitfähigkeitstyps gegenüber den weiteren MOS-Zellen (SU) lateral isoliert sind, wobei diese Gebiete (13) gegenüber den Wannen der MOS-Zellen (M) weniger weit in das Substrat hineinreichen.

10. Vertikales Halbleiter-Bauelement nach einem der Patentansprüche 1 bis 8,
**dadurch gekennzeichnet, daß**
einige Gebiete (13) der Gebiete (11) des zweiten Leitfähigkeitstyps gegenüber den weiteren MOS-Zellen (SU) lateral isoliert sind, wobei die Dotierung dieser Gebiete (13) so gewählt ist, daß die Durchbruchsspannung geringer als die Durchbruchsspannung der MOS-Zellen (M) ist.

11. Laterales Halbleiter-Bauelement mit folgenden Merkmalen:
- einem ersten Substrat (1) vom ersten Leitfähigkeitstyp mit einer ersten und einer zweiten Seite (I, II), das auf der ersten Seite (I) von einer Isolierschicht bedeckt ist;
- einem auf der zweiten Seite (II) aufgebrachten zweiten Substrat vom zweiten Leitfähigkeitstyp;
- einer Vielzahl von MOS-Zellen (M) auf der ersten Seite (I) zur Bildung eines ersten Halbleiter-Schalters, wobei eine MOS-Zelle (M) jeweils aufweist:
- eine in das Substrat eingebrachte und an die erste Seite reichende erste Wanne (4) vom zweiten Leitfähigkeitstyp,
- ein in die erste Wanne (4) eingebrachtes und an die erste Seite (I) reichendes erstes Source-Gebiet (5), das über eine, durch die Isolierschicht (8) gehende, erste Source-Elektrode (6) elektrisch kontaktiert ist,
- ein in das Substrat (1) eingebrachtes und an die erste Seite reichendes Drain-Gebiet (2), das über eine durch die Isolierschicht (8) gehende Drain-Elektrode (3) elektrisch kontaktierbar ist,
- ein auf der vom ersten Substrat abgewandten Seite der Isolierschicht aufgebrachtes erstes Gate (7), das zumindest das erste Source-Gebiet (5) teilweise überdeckt;
- einer Mehrzahl an weiteren MOS-Zellen (SU), zur Bildung eines zweiten Halbleiter-Schalters, der mit dem ersten Halbleiter-Schalter einen gemeinsamen Drain-Anschluß besitzt, wobei die weiteren MOS-Zellen (SU) jeweils aufweisen:
eine in das Substrat eingebrachte und an die erste Seite reichende zweite Wanne (4') vom zweiten Leitfähigkeitstyp, ein in die zweite Wanne (4') eingelassenes und an die erste Seite reichendes zweites Source-Gebiet (5') vom ersten Leitungstyp, das über eine durch die Isolierschicht gehende zweite Source-Elektrode (6') elektrisch kontaktierbar ist, sowie ein das zweite Source-Gebiet (5') zumindest teilweise überdeckendes, zweites Gate (7'),
**dadurch gekennzeichnet, dass**
die zweite Source-Elektrode (6') von der ersten Source-Elektrode (6) elektrisch isoliert ist und dass
zumindest ein in das Substrat eingelassenes und an die erste Seite reichendes Gebiet (11, 11') vom zweiten Leitfähigkeitstyp vorhanden ist, das elektrisch mit dem zweiten Gate (7') verbunden ist und das floatend angeordnet ist.

12. Laterales Halbleiter-Bauelement nach Patentanspruch 11,
**dadurch gekennzeichnet, daß**
das erste und/oder zweite Source-Gebiet (5, 5') aus einer Wanne vom zweiten Leitfähigkeitstyp besteht, in welcher ein an die erste Seite reichendes Gebiet vom ersten Leitfähigkeitstyp eingelassen ist, das mit der jeweiligen Source-Elektrode (6, 6') verbunden ist.

13. Laterales Halbleiter-Bauelement nach Patentanspruch 11 oder 12,
**dadurch gekennzeichnet, daß**
zumindest ein Gebiet (11, 11') des zweiten Leitfähigkeitstyps ausschließlich von den zweiten Source-Gebieten (5') umgeben ist.

14. Laterales Halbleiter-Bauelement nach Patentanspruch 11 oder 12,
**dadurch gekennzeichnet, daß**
zumindest ein zweites Source-Gebiet (5') ausschließlich von den Gebieten (11, 11') des zweiten Leitfähigkeitstyps umgeben ist.

15. Laterales Halbleiter-Bauelement nach Patentanspruch 13 oder 14,
**dadurch gekennzeichnet, daß**
die Struktur (11, 11', 5') mit den zweiten Source-Gebieten (5') und dem Gebiet (11, 11') vom zweiten Leitfähigkeitstyp benachbart zu den MOS-Zellen (M) angeordnet ist oder von den MOS-Zellen (M) umgeben ist.

16. Laterales Halbleiter-Bauelement nach Patentanspruch 13 bis 15,
**dadurch gekennzeichnet, daß**
zwischen den MOS-Zellen (M) und der Struktur (11, 11', 5') mit den zweiten Source-Gebieten (5') und dem Gebiet (11, 11') vom zweiten Leitfähigkeitstyp eine laterale Isolation (9) vorgesehen ist.

17. Laterales Halbleiter-Bauelement nach Patentanspruch 11 bis 16,
**dadurch gekennzeichnet, daß**
mit dem Gebiet (11, 11') des zweiten Leitfähigkeitstyps ein weiteres Gebiet derart verbunden ist, daß die darin vorhandene Ladung durch die Ausbreitung einer Raumladungszone zwischen dem zweiten Source-Gebiet (5') und dem Gebiet (11, 11') des zweiten Leitfähigkeitstyps in der Lage ist, das zweite Gate anzusteuern.

18. Laterales Halbleiter-Bauelement nach Patentanspruch 17,
**dadurch gekennzeichnet, daß**
sich das weitere Gebiet in Richtung der Drain-Elektrode im ersten Substrat erstreckt.

19. Laterales Halbleiter-Bauelement nach Patentanspruch 18,
**dadurch gekennzeichnet, daß**
sich das weitere Gebiet entlang der ersten Seite erstreckt.

20. Halbleiter-Bauelement nach einem der Patentansprüche 1 bis 19,
**dadurch gekennzeichnet, daß**
der erste Leitfähigkeitstyp n-leitend ist.

21. Halbleiter-Bauelement nach einem der Patentansprüche 1 bis 20,
**dadurch gekennzeichnet, daß**
die weiteren MOS-Zellen (SU) und/oder die Gebiete (11, 11') kaskadiert verschaltet sind.

## Claims

1. Vertical semiconductor component having the following features:
- a substrate (1) of the first conductivity type having a first and a second side (I, II) which substrate is covered by an insulating layer (8) on the first side (I);
- a more highly doped layer (2) of the first conductivity type, which layer is applied on the second side (II) and on which layer a metallic drain contact (3) is applied;
- a multiplicity of MOS cells (M) on the first side of the substrate (1) for forming a first semiconductor switch, a MOS cell in each case having:
- a first well (4) of the second conductivity type, which first well is introduced into the substrate and reaches to the first side,
- a first source region (5) of the first conductivity type, which source region is incorporated into the first well (4), reaches to the first side of the substrate (1) and is connected to a first metallic source contact (6) extending through the insulating layer (8),
- a first gate (7) on that side of the insulating layer (8) which is remote from the substrate (1), which gate partly covers the first well (4) and is connected to a metallic gate contact;
- a plurality of further MOS cells (SU) for forming a second semiconductor switch, which has a drain terminal shared with the first semiconductor switch, the further MOS cells (SU) in each case having:
- a second well (4') of the second conductivity type, which second well is introduced into the substrate and reaches to the first side, a second source region (5') of the first conductivity type, which source region is incorporated into the second well (4'), reaches to the first side of the substrate (1) and is connected to a second metallic source contact (6'), on the first side (I) and extending through the insulating layer (8),
- a second gate (7') on that side of the insulating layer (8) which is remote from the substrate (1), which gate partly covers the second well (4') and is connected to a metallic gate contact;
**characterized in that**
the second source contact (6') is electrically insulated from the first source contact (6) and **in that**
there is at least one region (11, 11') of the second conductivity type, which region is incorporated into the substrate, reaches to the first side, is electrically connected to the second gate (7') of the further MOS cells (SU) and is arranged in a floating manner with respect to the first and second source regions (5, 5').

2. Vertical semiconductor component according to claim 1,
**characterized in that**
a region (11, 11') of the second conductivity type is surrounded exclusively by the further MOS cells (SU).

3. Vertical semiconductor component according to claim 1,
**characterized in that**
at least one of the further MOS cells (SU) is surrounded exclusively by regions (11, 11') of the second conductivity type.

4. Vertical semiconductor component according to claim 2 or 3,
**characterized in that**
a structure (11, 11', SU) with the further MOS cells (SU) and the region (11, 11') of the second conductivity type is arranged adjacent to the MOS cells (M) of the first semiconductor switch or is surrounded by the MOS cells (M).

5. Vertical semiconductor component according to one of claims 2 to 4,
**characterized in that**
a lateral insulation (9) is provided between the MOS cells (M) and the structure (11, 11', SU) with the further MOS cells (SU) and the region (11, 11') of the second conductivity type.

6. Vertical semiconductor component according to one of claims 1 to 5,
**characterized in that**
the region (11, 11') of the second conductivity type is formed in such a way in the direction of the second side (II) that the charge present therein, by virtue of the propagation of a space charge zone between the further MOS cells (SU) and the region (11, 11') of the second conductivity type, is able to drive the gate of the further MOS cells (SU).

7. Vertical semiconductor component according to claim 6,
**characterized in that**
the regions (11') of the second conductivity type are extended orthogonally from the first side (I) toward the second side (II).

8. Vertical semiconductor component according to one of claims 1 to 7,
**characterized in that**
the wells (4, 4') of the MOS cells (M) and further MOS cells (SU) are extended orthogonally from the first side (I) to the second side (II).

9. Vertical semiconductor component according to one of claims 1 to 8,
**characterized in that**
some regions (13) of the regions (11) of the second conductivity type are laterally insulated from the further MOS cells (SU), these regions (13) reaching into the substrate to a lesser extent than the wells of the MOS cells (M).

10. Vertical semiconductor component according to one of claims 1 to 8,
**characterized in that**
some regions (13) of the regions (11) of the second conductivity type are laterally insulated from the further MOS cells (SU), the doping of these regions (13) being chosen such that the breakdown voltage is less than the breakdown voltage of the MOS cells (M).

11. Lateral semiconductor component having the following features:
- a first substrate (1) of the first conductivity type having a first and a second side (I, II) which substrate is covered by an insulating layer on the first side (I);
- a second substrate of the second conductivity type, which substrate is applied on the second side (II);
- a multiplicity of MOS cells (M) on the first side (I) for forming a first semiconductor switch, a MOS cell (M) in each case having:
- a first well (4) of the second conductivity type, which first well is introduced into the substrate and reaches to the first side,
- a first source region (5), which is introduced into the first well (4), reaches to the first side (I) and is electrically contact-connected via a first source electrode (6) passing through the insulating layer (8),
- a drain region (2), which is introduced into the substrate (1), reaches to the first side and can be electrically contact-connected via a drain electrode (3) passing through the insulating layer (8),
- a first gate (7), which is applied on that side of the insulating layer which is remote from the first substrate and partly covers at least the first source region (5);
- a plurality of further MOS cells (SU) for forming a second semiconductor switch, which has a drain terminal shared with the first semiconductor switch, the further MOS cells (SU) in each case having:
- a second well (4') of the second conductivity type, which second well is introduced into the substrate and reaches to the first side, a second source region (5') of the first conductivity type, which source region is incorporated into the second well (4'), reaches to the first side of the substrate (1) and can be electrically contact-connected via a second source electrode (6') passing through the insulating layer, and also a second gate (7'), which at least partly covers the second source region (5'),
**characterized in that**
the second source electrode (6') is electrically insulated from the first source electrode (6) and **in that**
there is at least one region (11, 11') of the second conductivity type, which region is incorporated into the substrate, reaches to the first side, is electrically connected to the second gate (7') and is arranged in a floating manner.

12. Lateral semiconductor component according to claim 11,
**characterized in that**
the first and/or second source region (5, 5') comprises a well of the second conductivity type, in which well a region of the first conductivity type is incorporated, which region reaches to the first side and is connected to the respective source electrode (6, 6').

13. Lateral semiconductor component according to claim 11 or 12,
**characterized in that**
at least one region (11, 11') of the second conductivity type is surrounded exclusively by the second source regions (5').

14. Lateral semiconductor component according to claim 11 or 12,
**characterized in that**
at least one second source region (5') is surrounded exclusively by the regions (11, 11') of the second conductivity type.

15. Lateral semiconductor component according to claim 13 or 14,
**characterized in that**
the structure (11, 11', 5') with the second source regions (5') and the region (11, 11') of the second conductivity type is arranged adjacent to the MOS cells (M) or is surrounded by the MOS cells (M).

16. Lateral semiconductor component according to claims 13 to 15,
**characterized in that**
a lateral insulation (9) is provided between the MOS cells (M) and the structure (11, 11', 5') with the second source regions (5') and the region (11, 11') of the second conductivity type.

17. Lateral semiconductor component according to claims 11 to 16,
**characterized in that**
a further region is connected to the region (11, 11') of the second conductivity type in such a way that the charge present therein, by virtue of the propagation of a space charge zone between the second source region (5') and the region (11, 11') of the second conductivity type, is able to drive the second gate.

18. Lateral semiconductor component according to claim 17,
**characterized in that**
the further region extends in the direction of the drain electrode in the first substrate.

19. Lateral semiconductor component according to claim 18,
**characterized in that**
the further region extends along the first side.

20. Semiconductor component according to one of claims 1 to 19,
**characterized in that**
the first conductivity type is n-conducting.

21. Semiconductor component according to one of claims 1 to 20,
**characterized in that**
the further MOS cells (SU) and/or the regions (11, 11') are connected up in a cascaded manner.

## Revendications

1. Composant à semiconducteurs vertical ayant les caractéristiques suivantes :
- un substrat (1) d'un premier type de conductivité, ayant une première et une deuxième faces (I, II), qui est revêtu sur la première face (I) d'une couche (8) isolante,
- une couche (II) du premier type de conductivité, plus dopée, déposée sur la deuxième face (2) et sur laquelle est déposée une couche (3) métallique de drain,
- une pluralité de cellules (M) MOS sur la première face du substrat (1) pour la formation d'un premier commutateur à semiconducteurs, dans lequel une cellule MOS a respectivement :
- une première cuvette (4) du deuxième type de conductivité ménagée dans le substrat et allant jusqu'à la première face,
- une première zone (5) de source du premier type de conductivité, qui est enchâssée dans la première cuvette (4), qui va jusqu'à la première face du substrat (1) et qui est reliée à un premier contact (6) de source métallique qui traverse la couche (8) isolante,
- une première grille (7) qui est sur la face de la couche (8) isolante éloignée du substrat (1), qui recouvre partiellement la première cuvette (4) et qui est reliée à un contact de grille métallique ;
- une pluralité d'autres cellules (SU) MOS pour la formation d'un deuxième commutateur à semiconducteurs, qui possède une borne de drain commune avec le premier commutateur à semiconducteurs, les autres cellules (SU) MOS ayant respectivement :
- une deuxième cuvette (4') du deuxième type de conductivité, qui est ménagée dans le substrat et qui va jusqu'à la première face, une deuxième zone (5') de source du premier type de conductivité, qui est enchâssée dans la deuxième cuvette (4'), qui va jusqu'à la première face du substrat (1) et qui est reliée à un deuxième contact (6') de source métallique sur la première face (I) contact, qui traverse la couche (8) isolante,
- une deuxième grille (7'), qui est sur la face de la couche (8) isolante éloignée du substrat (1), qui recouvre partiellement la deuxième cuvette (4') et qui est reliée à un contact de grille métallique,
**caractérisé en ce que**
le deuxième contact (6') de source est isolé électriquement du premier contact (6) de source et **en ce que**
il y a au moins une zone (11, 11') du deuxième type de conductivité, qui est enchâssée dans le substrat, qui va jusqu'à la première face, qui est en liaison électrique avec la deuxième grille (7') des autres cellules (SU) MOS et qui est montée flottante par rapport à la première et à la deuxième zone (5, 5') de source.

2. Composant à semiconducteurs vertical suivant la revendication 1, **caractérisé en ce qu'**une zone (11, 11') du deuxième type de conductivité est entourée exclusivement par les autres cellules (SU) MOS.

3. Composant à semiconducteurs vertical suivant la revendication 1, **caractérisé en ce qu'**au moins l'une des autres cellules (SU) MOS est entourée exclusivement de zones (11, 11') du deuxième type de conductivité.

4. Composant à semiconducteurs vertical suivant la revendication 2 ou 3, **caractérisé en ce qu'**une structure (11, 11', SU), ayant les autres cellules (SU) MOS et la zone (11, 11') du deuxième type de conductivité, est disposée au voisinage des cellules (M) MOS du premier commutateur à semiconducteurs ou est entourée des cellules (M) MOS.

5. Composant à semiconducteurs vertical suivant l'une des revendications 2 à 4, **caractérisé en ce qu'**il est prévu un isolant (9) latéral entre les cellules (M) MOS et la structure (11, 11', SU) ayant les autres cellules (SU) MOS et la zone (11, 11') du deuxième type de conductivité.

6. Composant à semiconducteurs vertical suivant l'une des revendications 1 à 5, **caractérisé en ce que** la zone (11, 11') du deuxième type de conductivité est constituée dans la direction de la deuxième face (II) de manière à ce que la charge qui s'y trouve soit en mesure, par la propagation d'une zone de charge d'espace entre les autres cellules (SU) MOS et la zone (11, 11') du deuxième type de conductivité, de commander la grille des autres cellules (SU) MOS.

7. Composant à semiconducteurs vertical suivant la revendication 6, **caractérisé en ce que** les zones (11, 11') du deuxième type de conductivité s'étendent orthogonalement de la première face (I) à la deuxième face (II).

8. Composant à semiconducteurs vertical suivant l'une des revendications 1 à 7, **caractérisé en ce que** les cuvettes (4, 4') des cellules MOS et des autres cellules (SU) MOS s'étendent orthogonalement de la première face (I) à la deuxième face (II).

9. Composant à semiconducteurs vertical suivant l'une des revendications 1 à 8, **caractérisé en ce que** certaines zones (13) parmi les zones (11) du deuxième type de conductivité sont isolées latéralement des autres cellules (SU) MOS, ces zones allant moins loin dans le substrat que les cuvettes des cellules MOS.

10. Composant à semiconducteurs vertical suivant l'une des revendications 1 à 8, **caractérisé en ce que** certaines zones (13) parmi les zones (11) du deuxième type de conductivité sont isolées latéralement des autres (SU) MOS, le dopage de ces zones (13) étant choisi de manière à ce que la tension de claquage soit plus basse que la tension de claquage des cellules (M) MOS.

11. Composant à semiconducteurs latéral ayant les caractéristiques suivantes :
- un premier substrat (1) du premier type de conductivité, ayant une première et une deuxième faces (I, II), qui est revêtu d'une couche isolante sur la première face (I) ;
- un deuxième substrat du deuxième type de conductivité déposé sur la deuxième face (II) ;
- une pluralité de cellules (M) MOS sur la première face (I) pour la formation d'un premier commutateur à semiconducteurs, une cellule (M) MOS ayant respectivement :
- une première cuvette (4) du deuxième type de conductivité, ménagée dans le substrat et allant jusqu'à la première face,
- une première zone (5) de source, qui est ménagée dans la première cuvette, qui va jusqu'à la première face (I) et qui est contactée électriquement par une première électrode (6) de source traversant la couche (8) isolante,
- une zone (2) de drain, qui est ménagée dans le substrat (1), qui va jusqu'à la première face et qui peut être contactée électriquement par une électrode (3) de drain traversant la couche (8) isolante,
- une première grille (7), qui est déposée sur la face de la couche isolante éloignée du premier substrat et qui recouvre partiellement au moins la première zone (5) de source,
- une multiplicité d'autres cellules (SU) MOS pour la formation d'un deuxième commutateur à semiconducteurs, qui a une borne de drain commune avec le premier commutateur à semiconducteurs, les autres cellules (SU) MOS ayant respectivement :
une deuxième cuvette (4') du deuxième type de conductivité ménagée dans le substrat et allant jusqu'à la première face, une deuxième zone (5') de source du premier type de conductivité, qui est enchâssée dans la deuxième cuvette (4'), qui va jusqu'à la première face et qui peut être contactée électriquement par une deuxième électrode (6') de source traversant la couche isolante, ainsi qu'une deuxième grille (7') recouvrant au moins partiellement la deuxième zone (5') de source,
**caractérisé en ce que**
la deuxième électrode (6') de source est isolée électriquement de la première électrode de source et **en ce que**
il y a au moins une zone (11, 11') du deuxième type de conductivité, qui est enchâssée dans le substrat, qui va jusqu'à la première face, qui est reliée électriquement à la deuxième grille (7') et qui est montée flottante.

12. Composant à semiconducteurs vertical suivant la revendication 11, **caractérisé en ce que** la première et/ou la deuxième zone (5, 5') de source sont en une cuvette du deuxième type de conductivité, dans laquelle est enchâssée une zone de premier type de conductivité allant jusqu'à la première face et reliée à l'électrode (6, 6') de source respective.

13. Composant à semiconducteurs vertical suivant la revendication 11 ou 12, **caractérisé en ce qu'**au moins une zone (11, 11') du deuxième type de conductivité est entourée exclusivement de la deuxième zone (5') de source.

14. Composant à semiconducteurs vertical suivant la revendication 11 ou 12, **caractérisé en ce qu'**une deuxième zone (5') de source est entourée exclusivement des zones (11, 11') du deuxième type de conductivité.

15. Composant à semiconducteurs vertical suivant la revendication 13 ou 14, **caractérisé en ce que** la structure (11, 11', 5') ayant les deuxièmes zones (5') de source et la zone (11, 11') du deuxième type de conductivité est disposée au voisinage des cellules (M) MOS ou est entourée des cellules (M) MOS.

16. Composant à semiconducteurs vertical suivant l'une des revendications 13 à 15, **caractérisé en ce qu'**il est prévu un isolant (9) latéral entre les cellules (M) MOS et la structure (11, 11', 5') ayant les deuxièmes zones (5') de source et la zone (11, 11') du deuxième type de conductivité.

17. Composant à semiconducteurs vertical suivant l'une des revendications 11 à 16, **caractérisé en ce qu'**à la zone (11, 11') du deuxième type de conductivité est reliée une autre zone de manière à ce que la charge qui s'y trouve soit en mesure, par la propagation d'une zone de charge d'espace entre la deuxième zone (5') de source et la zone (11, 11') du deuxième type de conductivité, de commander la deuxième grille.

18. Composant à semiconducteurs vertical suivant la revendication 17, **caractérisé en ce que** l'autre zone s'étend dans le premier substrat dans la direction de l'électrode de drain.

19. Composant à semiconducteurs vertical suivant la revendication 18, **caractérisé en ce que** l'autre zone s'étend le long de la première face.

20. Composant à semiconducteurs vertical suivant la revendication 1 à 19, **caractérisé en ce que** le premier type de conductivité est une conductivité n.

21. Composant à semiconducteurs vertical suivant l'une des revendications 1 à 20, **caractérisé en ce que** les autres cellules (SU) MOS et/ou les zones (11, 11') sont montées en cascade.
